# EUROPÄISCHE PATENTSCHRIFT

(11) **EP 2 984 755 B1**
(45) Veröffentlichungstag und Bekanntmachung des Hinweises auf die Patenterteilung: **30.09.2020**
(21) Anmeldenummer: 14717394.2
(22) Anmeldetag: 15.03.2014
(51) Int. Cl.: H03H 7/00

(54) **EFFIZIENTER PASSIVER BREITBANDIGER GYRATOR**
EFFICIENT PASSIVE BROADBAND GYRATOR
GYRATEUR LARGE BANDE PASSIF PLUS EFFICACE

(30) Priorität: 13.04.2013 DE 102013006377
(43) Veröffentlichungstag der Anmeldung: 17.02.2016
(73) Patentinhaber: Forschungszentrum Jülich GmbH, 52425 Jülich (DE)
(72) Erfinder: DIVINCENZO, David, NL-6367 DA Voerendaal (NL)
(86) Internationale Anmeldenummer: PCT/DE2014/000136
(87) Internationale Veröffentlichungsnummer: WO 2014/166465

(56) Entgegenhaltungen:
- DE-B- 1 144 355
- DE-B- 1 147 278
- US-A- 3 047 821
- US-A- 3 214 682
- R. F. WICK: "Solution of the Field Problem of the Germanium Gyrator", JOURNAL OF APPLIED PHYSICS, Bd. 25, Nr. 6, 1. Januar 1954 (1954-01-01) , Seite 741, XP055122858, ISSN: 0021-8979, DOI: 10.1063/1.1721725
- BRUNA M ET AL: "Fabrication and characterization of graphene-based quantum hall effect devices at INRIM", PRECISION ELECTROMAGNETIC MEASUREMENTS (CPEM), 2010 CONFERENCE ON, IEEE, PISCATAWAY, NJ, USA, 13. Juni 2010 (2010-06-13), Seiten 349-350, XP031729430, ISBN: 978-1-4244-6795-2
- SOSSO A: "Derivation of an electronic equivalent of QHE devices", PRECISION ELECTROMAGNETIC MEASUREMENTS DIGEST, 2000 CONFERENCE ON, IEEE, 14. Mai 2000 (2000-05-14), Seiten 519-520, XP032400133, DOI: 10.1109/CPEM.2000.851110 ISBN: 978-0-7803-5744-0

## Beschreibung

Die Erfindung betrifft einen Gyrator für Wechselstromsignale.

Ein Gyrator ist ein elektrisches Zweitorbauelement, bei dem die Spannung am Ausgang proportional zum Strom am Eingang ist, wobei das Vorzeichen der Spannung wechselt, wenn Eingang und Ausgang vertauscht werden. Ist der Strom ein Wechselstrom, wird er somit entweder in eine gleichphasige oder in eine gegenphasige Wechselspannung umgewandelt, je nachdem an welchem Tor des Gyrators dieser Strom vorgelegt wird. Als fünftes lineares Element neben Widerstand, Kapazität, Induktivität und idealem Transformator ist er notwendig, um Zweitorbauelemente, die eine Wechselspannung nur in einer Richtung durchlassen (Isolatoren), oder Drei-oder Mehrtorbauelemente, die eine Wechselspannung an einem Tor nur zu einem in einer festen Rotationsrichtung nächsten Tor durchlassen (Zirkulatoren), zu realisieren.

Um die Umwandlung des Eingangsstroms in die Ausgangsspannung von der Stromrichtung durch den Gyrator abhängig zu machen, wird im Mikrowellenbereich die Faraday-Rotation in Ferriten unter dem Einfluss eines externen Magnetfelds verwendet. Dazu ist es notwendig, dass sich eine durch den Eingangsstrom erzeugte elektromagnetische Welle in dem Ferriten ausbreitet. Der Ferrit muss daher Abmessungen von der Größenordnung der Wellenlänge haben und wird daher für Frequenzen im Radio- oder Tonfrequenzbereich unpraktikabel groß. Er arbeitet bei Frequenzen unterhalb des Mikrowellenbereichs auch nicht mehr effizient. Zudem ist jeder Gyrator durch seine physikalischen Abmessungen auf ein mehr oder weniger schmales Frequenzband festgelegt.

Alternativ lässt sich ein Gyrator auch als aktive Schaltung aus Transistoren und rückgekoppelten Operationsverstärkern realisieren. Eine solche Schaltung benötigt jedoch eine Energieversorgung und produziert sowohl Rauschen als auch Wärme.

Aus der US-Patentschrift 2,649,574 ist ein passiver Gyrator für tiefere Frequenzen bekannt, bei dem die Faraday-Rotation im Ferrit durch den planaren Hall-Effekt ersetzt wird. Nachteilig werden sowohl die Einkopplung des Stroms in das Hall-Effekt-Material als auch das Abgreifen der Hall-Spannung durch hohe Kontaktwiderstände behindert, was die Effizienz des Gyrators beeinträchtigt.

Die deutsche Auslegeschrift 11 44 355 offenbart eine elektrische Übertragungsvorrichtung mit zwei Paar Elektroden bei der die Elektroden beider Elektrodenpaare und die daran angeschlossenen Leitungen künstlich näherungsweise anisotrop sind, in dem diese Elektroden in mindestens zwei miteinander getrennten Teilleitungen verbundene Teilelektroden aufgespalten sind, oder bei der die Elektrodenpaare und die daran angeschlossenen Leitungen durch anisotrop wirkende induktive Kopplungen ersetzt sind.

Die deutsche Auslegeschrift 11 47 278 zeigt eine aus einem Gyrator und einem Übertragungstransformator aufgebaute Übertragungsvorrichtung mit bevorzugter Übertragungsvorrichtung bei der der Gyrator valent behaftet ist und die Kopplung über den Gyrator und die Kopplung über den Transformator derart aufeinander abgestimmt sind, dass in einer Richtung die über den Gyrator und die über den Transformator übertragenen Spannungen oder Ströme einander praktisch aufheben.

### Aufgabe und Lösung

Es ist daher die Aufgabe der Erfindung, einen Gyrator zur Verfügung zu stellen, der bei tiefen Frequenzen in der Größenordnung 1-100 MHz effizienter arbeitet als Gyratoren nach dem bisherigen Stand der Technik.

Diese Aufgabe wird erfindungsgemäß gelöst durch einen Gyrator gemäß Hauptanspruch. Weitere vorteilhafte Ausgestaltungen ergeben sich aus den darauf rückbezogenen Unteransprüchen.

### Gegenstand der Erfindung

Im Rahmen der Erfindung wurde ein Gyrator für Wechselstromsignale entwickelt. Dieser umfasst ein Hall-Effekt-Material, Mittel zum Einkoppeln eines Wechselstroms (I₁; I₄) in das Hall-Effekt-Material, Mittel zur Durchsetzung des Hall-Effekt-Materials mit einem zu seiner Ebene oder Oberfläche senkrechten Magnetfeld sowie Mittel zur Umwandlung eines Stroms (I₃; I₂), der durch den Strom I₁ senkrecht zum von I₁ erzeugten elektrischen Feld im Hall-Effekt-Material generiert wurde, in eine Ausgangsspannung (U₄; U₁).

Wird ein Wechselstrom I₁ am ersten Tor des Gyrators angelegt und durch das Hall-Effekt-Material getrieben, werden die Elektronen, die diesen Strom tragen, durch das Magnetfeld senkrecht zur Stromrichtung abgelenkt. Der Gesamtstrom erhält dadurch eine Komponente I₃, die senkrecht auf dem von I₁ erzeugten elektrischen Feld steht. Dieser lässt sich in die Ausgangsspannung U₄ umwandeln. Die Ausgangsspannung U₄ lässt sich beispielsweise am Hall-Effekt-Material als Hall-Spannung senkrecht zur Richtung des Stroms I₁ abgreifen. Wird am zweiten Tor des Gyrators ein Wechselstrom I₄ angelegt, ändert sich bei gleicher Magnetfeldrichtung auf Grund der Rechte-Hand-Regel die Richtung der durch die Ablenkung bewirkten Stromkomponente I₂. Dementsprechend kehrt sich das Vorzeichen der Ausgangsspannung U₁ um.

Erfindungsgemäß ist für die Einkopplung des Stroms (I₁; I₄) in das Hall-Effekt-Material und für die Umwandlung des Stroms (I₃; I₂) im Hall-Effekt-Material in die Ausgangsspannung (U₄; U₁) je ein Transformator vorgesehen, der mindestens eine Leiterschleife aus einem normalleitenden oder halbleitenden Material und mindestens eine Leiterschleife aus dem Hall-Effekt-Material umfasst.

Es wurde erkannt, dass durch den Wegfall einer ineffizienten galvanischen Kopplung des Hall-Effekt-Materials an metallische oder halbleitende Leiter die bei der Umwandlung des Eingangsstroms (I₁; I₄) in die Ausgangsspannung (U₄; U₁) auftretenden dissipativen Verluste minimiert werden. Experimente der Quanteninformationsverarbeitung bei tiefen Temperaturen in der Größenordnung 10 mK sind so empfindlich, dass sie mit einem Isolator von der Messelektronik getrennt werden, damit das Messsignal vom Experiment möglichst ungestört zur Messelektronik gelangt, jedoch die Messelektronik kein Rauschen in das Experiment zurückstreut. Hierfür kommt nur ein Isolator auf der Basis eines passiven Gyrators in Frage, da ein aktiver Gyrator sowohl Wärme als auch Rauschen produziert. Gyratoren auf der Basis des Hall-Effekts nach dem bisherigen Stand der Technik sind für diesen Einsatzzweck ebenfalls nicht verwendbar, da die dissipativen Verluste das Messsignal abschwächen, unerwünschte Wärme produzieren und wie jeder ohmsche Widerstand Rauschen erzeugen. Der erfindungsgemäße Gyrator weist diese Nachteile nicht auf und ist für die beschriebenen Experimente einsetzbar. Mangels anderer verfügbarer Gyratoren und damit Isolatoren macht er etliche dieser Experimente erstmals praktikabel. Dabei hängt der Durchgriff des Eingangsstroms (I₁; I₄) auf die Ausgangsspannung (U₄; U₁) von der Stärke des Hall-Effekts im Hall-Effekt-Material ab. Diese Stärke wird beschrieben durch den Hall-Winkel θ_{H}, um den der Gesamtstrom durch das Hall-Effekt-Material vom durch I₁ erzeugten elektrischen Feld abgelenkt ist. Das Hall-Effekt-Materia! ist daher ein Material, das bei einer Magnetfeldstärke von 1 T einen Hall-Winkel θ_{H} von mindestens 80 Grad aufweist. Dazu umfasst das Hall-Effekt-Material vorteilhaft ein Halbmetall, insbesondere ein Halbmetall aus der Gruppe Arsen, α-Zinn (graues Zinn), Antimon, Wismut oder Graphit, und/oder einen dotierten Halbleiter. Die Stärke des Hall-Effekts ist im Wesentlichen ein Produkt aus intrinsischen Materialeigenschaften (hauptsächlich der Ladungsträgerdichte) und der Magnetfeldstärke. Je stärker der Hall-Winkel von 90 Grad abweicht, desto stärker wird ein Eingangsstrom (I₁; I₄) vom Gyrator reflektiert.

Der erfindungsgemäß vorgesehene Transformator beschränkt den Anwendungsbereich des Gyrators auf Wechselstromsignale. Es ist aber ein Betrieb mit Frequenzen bis hinab zu etwa 50 Hz möglich.

Für die Einkopplung ist ein erster Transformator und für die Umwandlung ist ein zweiter Transformator vorgesehen . Vorteilhaft sind die Leiterschleifen beider Transformatoren, die aus dem normalleitenden oder halbleitenden Material bestehen, induktiv voneinander entkoppelt. Ein Eingangsstrom I₁ bewirkt dann nur über den Hall-Effekt des Hall-Effekt-Materials eine Ausgangsspannung U₄, und umgekehrt bewirkt auch ein Eingangsstrom I₄ nur über diesen Hall-Effekt eine Ausgangsspannung U₁. Eine unter Umgehung des Hall-Effekt-Materials direkt induzierte Ausgangsspannung würde nachteilig nicht das Vorzeichen wechseln, wenn Eingang und Ausgang vertauscht werden.

In einer besonders vorteilhaften Ausgestaltung der Erfindung ist das Hall-Effekt-Material ein Quanten-Hall-Effekt-Material. In derartigen Materialien weicht θ_{H} nur um unmessbar kleine Beträge von 90 Grad ab. Der Eingangsstrom I₁ wird dann praktisch vollständig in den senkrechten Strom I₃ innerhalb des Hall-Effekt-Materials umgesetzt, der in die Ausgangsspannung U₄ umgewandelt wird. Der Quanten-Hall-Effekt tritt in vielen sehr dünnen Materialien und Strukturen auf. Vorteilhaft umfasst das Quanten-Hall-Effekt-Material Graphen und/oder eine Halbleiterheterostruktur, die ein zweidimensionales Elektronengas bildet.

Erfindungsgemäß ist das Hall-Effekt-Material dergestalt in mindestens zwei Leiterschleifen angeordnet, dass bei anliegendem Magnetfeld eine elektromotorische Kraft in einer der Leiterschleifen aus dem Hall-Effekt-Material des ersten Transformators einen Stromfluss hauptsächlich in einer der Leiterschleifen aus dem Hall-Effekt-Material des zweiten Transformators bewirkt. Der Eingangsstrom (I₁; I₄) bewirkt dann in der einen Leiterschleife eine elektromotorische Kraft, die durch den Hall-Effekt in einen Stromfluss durch die andere Leiterschleife umgewandelt wird. Dieser Stromfluss wird wiederum induktiv in die Ausgangsspannung (U₄; U₁) umgewandelt.

Dies ist beispielsweise in einer besonders vorteilhaften Ausgestaltung der Erfindung realisiert. In dieser Ausgestaltung bildet das Hall-Effekt-Material mindestens zwei Leiterschleifen 1 und 2, die an einem Punkt elektrisch miteinander verbunden sind und sich an mindestens einem anderen Punkt ohne elektrische Verbindung kreuzen. Diese Kreuzung kann beispielsweise realisiert sein, indem die eine Leiterschleife die andere über- oder unterquert, wobei sie durch einen Spalt und/oder durch ein isolierendes Material von der anderen Leiterschleife getrennt ist. Die eine Leiterschleife kann die andere aber auch durchqueren und dabei durch einen Spalt und/oder durch ein isolierendes Material von ihr getrennt sein. Die Leiterschleifen sind nicht auf Kreisform festgelegt, sondern können jede Form annehmen.

Das Hall-Effekt-Material kann beispielsweise in Form einer Spirale realisiert sein, deren Enden in einem gemeinsamen Kreuzungspunkt an eine der Windungen herangeführt oder mit diesem Kreuzungspunkt elektrisch kontaktiert sind.

In einer besonders vorteilhaften Ausgestaltung der Erfindung ist die eine Leiterschleife (1; 2) die Sekundärwicklung des Transformators für die Einkopplung des Eingangsstroms (I₁; I₄), und die zweite Leiterschleife (2; 1) ist die Primärwicklung des Transformators für die Umwandlung des Stroms (I₃; I₂) im Hall-Effekt-Material in die Ausgangsspannung (U₄; U₁). Die beiden Leiterschleifen erfüllen dann jeweils eine Doppelfunktion: Zum Einen separieren sie die interessierende Komponente (I₃; I₂) des Gesamtstroms im Hall-Effekt-Material in eine der Leiterschleifen ab. Zum Anderen bilden sie jeweils eine Hälfte des Transformators für die Einkopplung bzw. Umwandlung, so dass zusätzliche Teile hierfür eingespart werden.

In einer besonders vorteilhaften Ausgestaltung der Erfindung belegt das Hall-Effekt-Material eine dreidimensionale Fläche, die durch Bewegung einer zweidimensionalen Fläche auf einem geschlossenen Weg im Raum darstellbar ist. Diese Fläche kann beispielsweise ein Torus sein. Ein Torus entsteht, indem ein Kreis als zweidimensionale Fläche entlang eines größeren Kreises im dreidimensionalen Raum bewegt wird.

Das Hall-Effekt-Material kann insbesondere als Schicht auf einem isolierenden Substrat angeordnet sein, und/oder die dreidimensionale Fläche kann einen Hohlkörper aus dem Hall-Effekt-Material bilden. Beides hat die Wirkung, dass es nur Strompfade entlang der dreidimensionalen Fläche gibt und keine parasitären Strompfade durch ein massives Hall-Effekt-Material. Das Hall-Effekt-Material kann auf dem isolierenden Substrat aufgewachsen oder mit einer Beschichtungstechnik auf dieses Substrat aufgebracht sein.

Die dreidimensionale Fläche enthält automatisch Leiterschleifen 1 und 2, die an einem Punkt elektrisch miteinander verbunden sind und sich an mindestens einem anderen Punkt ohne elektrische Verbindung kreuzen. Die erste Leiterschleife 1 ist ein Pfad im Hall-Effekt-Material entlang des geschlossenen Weges oder parallel zu diesem Weg. Die zweite Leiterschleife 2 ist ein Pfad im Hall-Effekt-Material entlang des Umfangs der zweidimensionalen Fläche an einem Punkt des geschlossenen Weges. Diese Leiterschleife steht idealerweise senkrecht auf der ersten Leiterschleife. Beide Leiterschleifen 1 und 2 funktionieren wie oben beschrieben.

Die Anordnung auf der dreidimensionalen Fläche hat den Vorteil, dass eine besonders gute induktive Einkopplung des Eingangsstroms (I₁; I₄) in die eine Leiterschleife (1; 2) sowie eine besonders gute induktive Umwandlung des Stroms (I₃; I₂) im Hall-Effekt-Material in die Ausgangsspannung (U₄; U₁) realisiert werden kann. Der Gyrator wird dadurch insgesamt effizienter.

Vorteilhaft ist daher ein Pfad im Hall-Effekt-Material entlang des geschlossenen Weges oder parallel zu diesem Weg die Sekundärwicklung des Transformators für die Einkopplung des Eingangsstroms (I₁; I₄) oder die Primärwicklung des Transformators für die Umwandlung des Stroms (I₃; I₂) im Hall-Effekt-Material in die Ausgangsspannung (U₄; U₁). Die andere Wicklung des Transformators kann dann beispielsweise eine Spule sein, die entlang des geschlossenen Weges oder parallel zu diesem Weg gewickelt ist.

Alternativ oder in Kombination hierzu ist vorteilhaft ein Pfad im Hall-Effekt-Material entlang des Umfangs der zweidimensionalen Fläche an einem Punkt des geschlossenen Weges die Sekundärwicklung des Transformators für die Einkopplung des Eingangsstroms (I₁; I₄) oder die Primärwicklung des Transformators für die Umwandlung des Stroms (I₃; I₂) im Hall-Effekt-Material in die Ausgangsspannung (U₄; U₁). Die andere Wicklung des Transformators kann dann beispielsweise eine Spule sein, die entlang des Umfangs der zweidimensionalen Fläche gewickelt ist.

Ein in der beschriebenen Weise auf einer dreidimensionalen Fläche angeordneter Gyrator kommt mit einem räumlich homogenen Magnetfeld nicht mehr aus. Stattdessen ist jeweils lokal zu gewährleisten, dass das Magnetfeld senkrecht auf der dreidimensionalen Fläche steht. Je größer der Anteil der Fläche ist, auf dem dies realisiert werden kann, desto effizienter arbeitet der Gyrator. Vorteilhaft weist daher das Hall-Effekt-Material mindestens eine Öffnung zur Durchführung magnetischer Feldlinien durch die dreidimensionale Fläche auf. Alternativ oder auch in Kombination hierzu ist vorteilhaft eine magnetische Multipolanordnung zur Durchsetzung des Hall-Effekt-Materials mit dem Magnetfeld vorgesehen.

Vorteilhaft sind Mittel zur Erzeugung eines lokalen elektrischen Hilfsfelds an mindestens einem Ort auf der dreidimensionalen Fläche vorgesehen. Durch einen Feldeffekt kann dann die lokale Elektronendichte und damit der Hall-Effekt feinabgestimmt werden. Damit können eventuelle Inhomogenitäten der lokalen, zur dreidimensionalen Fläche senkrechten Komponente des Magnetfelds korrigiert werden. Um das Magnetfeld selbst feinabzustimmen, können auf der dreidimensionalen Fläche, in dem von dieser Fläche eingeschlossenen Körper oder in dessen Umfeld magnetisch permeable Materialien angeordnet sein.

### Spezieller Beschreibunqsteil

Nachfolgend wird der Gegenstand der Erfindung anhand von Figuren erläutert, ohne dass der Gegenstand der Erfindung hierdurch beschränkt wird. Es ist gezeigt:
- Figur 1:: Ausführungsbeispiel des erfindungsgemäßen Gyrators mit zwei Leiterschleifen aus Hall-Effekt-Material.
- Figur 2:: Ausführungsbeispiel des erfindungsgemäßen Gyrators mit einem Hall-EffektMaterial auf einer Torusoberfläche (a) mit zwei Strompfaden entlang der Torusoberfläche, die über Spulen (b, c) induktiv mit der Außenwelt verbunden sind.
- Figur 3:: Magnetische Multipolanordnung zur Realisierung eines homogenen senkrechten Feldes entlang der Torusoberfläche.

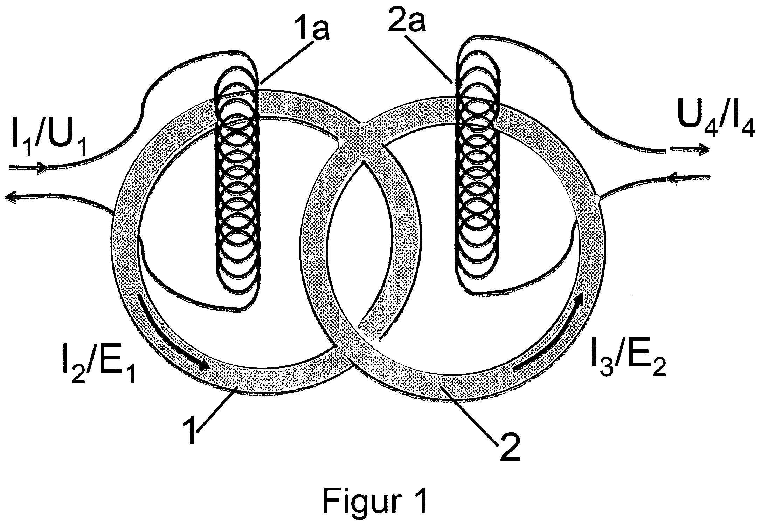

Figur 1 zeigt ein Ausführungsbeispiel des erfindungsgemäßen Gyrators in schematischer Darstellung. Das Hall-Effekt-Material ist in zwei Leiterschleifen 1 und 2 segmentiert. Das aus Gründen der Übersichtlichkeit nicht eingezeichnete Magnetfeld ist im Raum homogen und steht senkrecht auf der Zeichenebene. Um die Leiterschleifen 1 und 2 sind jeweils Spulen 1a und 2a gewickelt. Ein Eingangsstrom I₁, der über die Spule 1a eingekoppelt wird, bewirkt in der Leiterschleife 1 eine elektromotorische Kraft E₁. Der Hall-Effekt wandelt diese elektromotorische Kraft in einen Strom I₃ durch die Leiterschleife 2 um. Dieser induziert in der Spule 2a die Ausgangsspannung U₄. Wird umgekehrt die Spule 2a von einem Eingangsstrom I₄ durchflossen, bewirkt dies in der Leiterschleife 2 eine elektromotorische Kraft E₂. Auf Grund der Rechte-Hand-Regel wandelt der Hall-Effekt bei gleicher Magnetfeldrichtung diese elektromotorische Kraft E₂ in einen zum Eingangsstrom um 180° phasenverschobenen Strom I₂ durch die Leiterschleife 1 um. Dieser induziert in der Spule 1a die zum Eingangsstrom I₄ ebenfalls um 180° phasenverschobene Ausgangsspannung U₁.

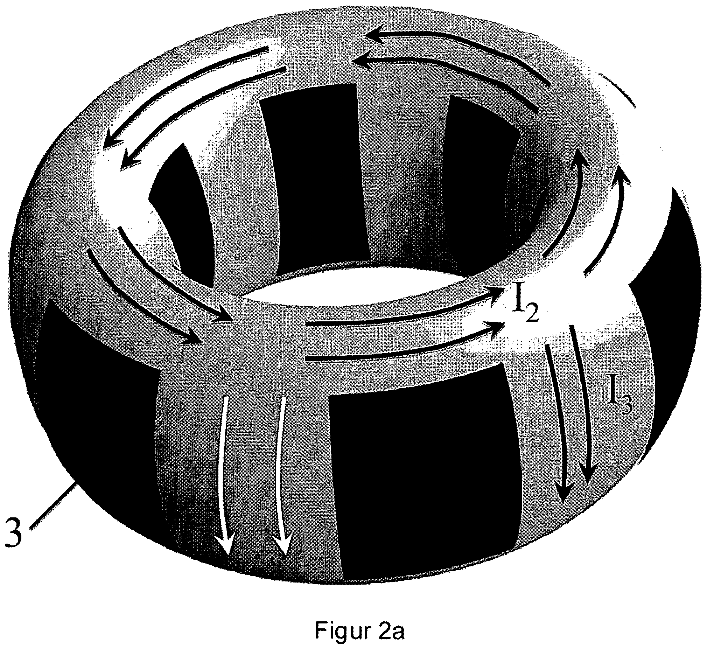

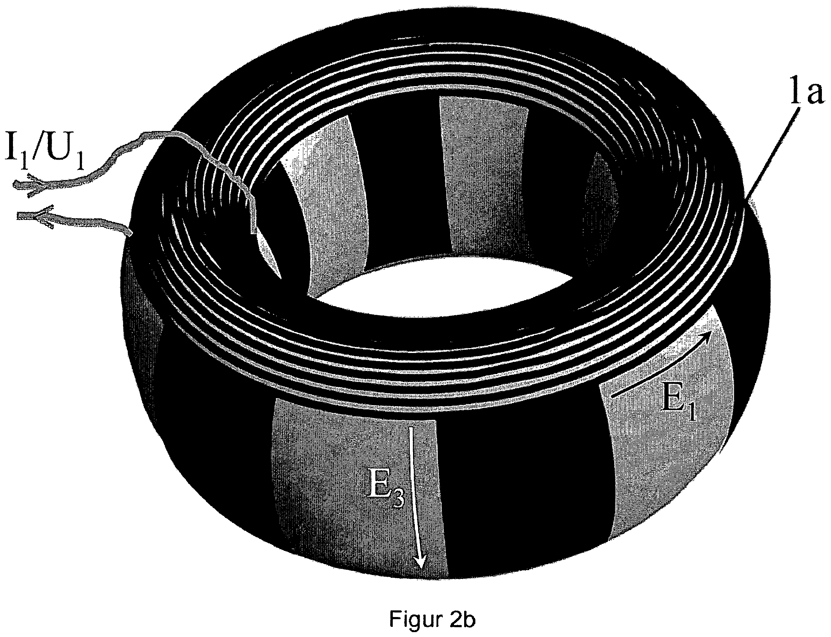

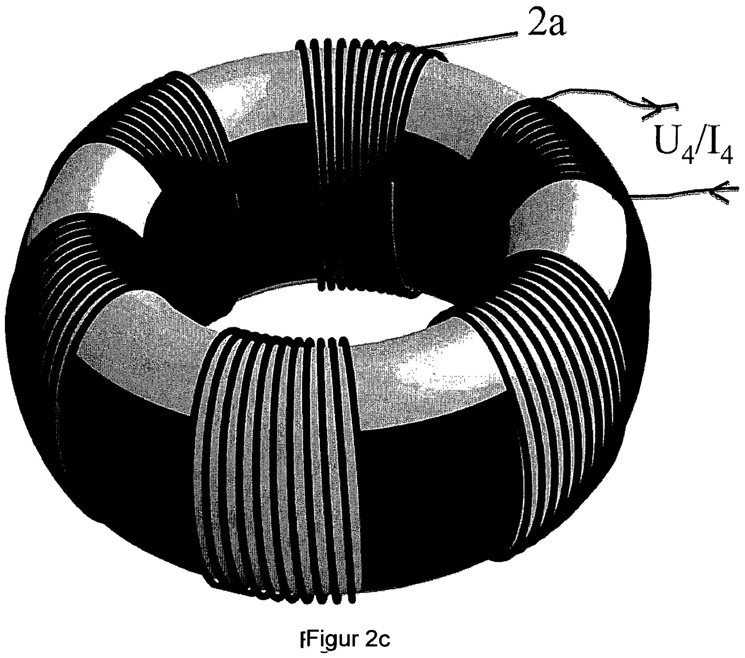

Figur 2 zeigt ein weiteres Ausführungsbeispiel des erfindungsgemäßen Gyrators. Das Hall-Effekt-Material ist hier auf der Oberfläche eines Torus angeordnet (Figur 2a). Das Liniennetz, das diese Oberfläche überzieht, dient nur der Verdeutlichung der dreidimensionalen Struktur für das Auge; die Schicht aus dem Hall-Effekt-Material ist in den hellgrauen Bereichen durchgehend. Sie ist lediglich durch die schwarz eingezeichneten Bereiche 3 unterbrochen, in denen keine Stromleitung stattfinden kann. Diese Bereiche dienen zum Einen dazu, den Durchtritt eines magnetischen Multipolfeldes durch die Torusoberfläche zu ermöglichen, damit möglichst überall auf dieser Oberfläche ein zu dieser Oberfläche senkrechtes Magnetfeld herrscht. Zum Anderen dienen sie dazu, definierte Bereiche zu formen, in denen der Strom I₃ entlang des Umfangs des Kreises, durch dessen Bewegung entlang eines größeren Kreises der Torus entstanden ist, fließen kann. In der hierzu senkrechten Richtung kann der Strom I₂ parallel zu dem größeren Kreis fließen.

Figur 2b zeigt eine Spule 1a zur induktiven Kopplung des in Figur 2a eingezeichneten Strompfades für I₂ mit der Außenwelt. Wird in die Spule ein Eingangsstrom I₁ eingekoppelt, wird entlang des Strompfades für I₂ ein elektrisches Feld E₁ erzeugt, das über den Hall-Effekt zu einem Strom I₃ in der hierzu senkrechten Richtung umgewandelt wird. Herrscht umgekehrt entlang des Pfades für den Strom I₃ eine elektromotorische Kraft, bewirkt der Hall-Effekt einen Strom I₂, der in der Spule die Ausgangsspannung U₁ induziert. Für eine optimale Wirkung des Gyrators sollte das räumliche Profil der Spule der räumlichen Verteilung des Stroms I₂ so weit wie möglich angenähert sein. Weiterhin ist vorteilhaft auf der Unterseite des Torus eine zweite, gleichartige Spule mit der in Figur 2b gezeigten Spule in Reihe geschaltet. Die Spule ist gegen das Hall-Effekt-Material elektrisch isoliert.

Figur 2c zeigt eine Spule 2a zur induktiven Kopplung des in Figur 2a eingezeichneten Strompfades für I₃ mit der Außenwelt. Die verschiedenen Stücke entlang des größeren der beiden Kreise, die den Torus definieren, sind in Reihe geschaltet. Fließt auf Grund eines Eingangsstroms I₁ durch die Spule 1a ein Strom I₃, wird dieser durch die Spule 2a in die Ausgangsspannung U₄ umgewandelt. Wird umgekehrt die Spule 2a mit dem Eingangsstrom I₄ beaufschlagt, wird entlang des Pfades für den Strom I₃ eine elektromotorische Kraft E₃ erzeugt, die durch den Hall-Effekt zu einem Strom I₂ umgewandelt wird und in der Spule 1a die Ausgangsspannung U₁ induziert. Die Spule 2a ist sowohl gegen die Spule 1a als auch gegen das Hall-Effekt-Material elektrisch isoliert. Es gibt auch keine direkte induktive Kopplung zwischen den Spulen 1a und 2a. Für eine optimale Wirkung des Gyrators sollte das räumliche Profil der Spule der räumlichen Verteilung des Stroms I₃ so weit wie möglich angenähert sein. Die Spule 2a kann die schwarz eingezeichneten Bereiche 3, in denen keine Stromleitung möglich ist, ganz oder teilweise überdecken.

Beide Spulen 1a oder 2a können jeweils auf der Innenseite oder auf der Außenseite der Torusoberfläche liegen. Es ist auch unerheblich, ob die Spule 1a über der Spule 2a liegt oder umgekehrt.

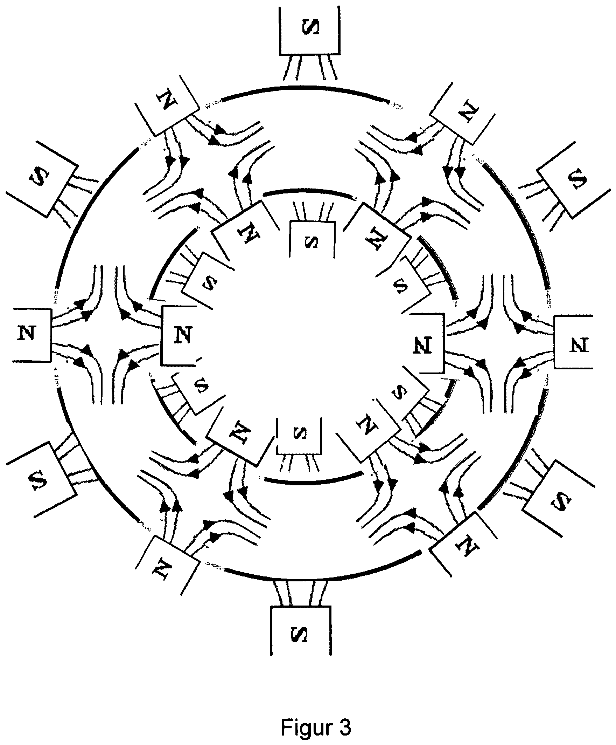

Figur 3 zeigt eine magnetische Multipolanordnung, die auf der Oberfläche des Torus ein homogenes senkrechtes Magnetfeld erzeugt, in Schnittzeichnung in der Äquatorebene des Torus. Die von magnetischen Nordpolen ausgehenden Feldlinien treten durch die Bereiche 3, in denen das Hall-Effekt-Material unterbrochen ist, in den Torus ein und treten senkrecht durch die mit Hall-Effekt-Material belegten Bereiche wieder aus dem Torus aus in Richtung der magnetischen Südpole. Vorteilhaft sind an der Außenfläche des Torus, etwa oberhalb und unterhalb der Zeichenebene, weitere Magnete vorgesehen, um dort weitere magnetische Südpole vorzulegen, so dass dort weitere Feldlinien senkrecht aus der Oberfläche austreten.

## Patentansprüche

1. Gyrator für Wechselstromsignale, umfassend ein Hall-Effekt-Material, Mittel zum Einkoppeln eines ersten Wechselstroms (I₁; I₄) in das Hall-Effekt-Material, Mittel zur Durchsetzung des Hall-Effekt-Materials mit einem zu seiner Ebene oder Oberfläche senkrechten Magnetfeld sowie Mittel zur Umwandlung eines zweiten Stroms (I₃; I₂), der durch den ersten Strom I₁ senkrecht zum von I₁ erzeugten elektrischen Feld im Hall-Effekt-Material generiert wurde, in eine Ausgangsspannung (U₄; U₁), wobei das Hall-Effekt-Material ein Material ist, das bei einer Magnetfeldstärke von 1 T einen Hall-Winkel θ_{H} von mindestens 80 Grad aufweist, wobei der Gyrator einen ersten Transformator für die Einkopplung des ersten Stroms (I₁; I₄) in das Hall-Effekt-Material und einen zweiten Transformator für die Umwandlung des zweiten Stroms (I₃; I₂) im Hall-Effekt-Material in die Ausgangsspannung (U₄; U₁) umfasst, wobei der erste Transformator und der zweite Transformator je mindestens eine Leiterschleife (1a; 2a) aus einem normalleitenden oder halbleitenden Material und mindestens eine Leiterschleife (1; 2) aus dem Hall-Effekt-Material umfasst, wobei das Hall-Effekt-Material dergestalt in den genannten mindestens zwei Leiterschleifen (1; 2) aus dem Hall-Effekt-Material angeordnet ist, dass bei anliegendem Magnetfeld eine elektromotorische Kraft in einer der Leiterschleifen aus dem Hall-Effekt-Material des ersten Transformators einen Stromfluss hauptsächlich in einer der Leiterschleifen aus dem Hall-Effekt-Material des zweiten Transformators bewirkt.

2. Gyrator nach Anspruch 1,
**dadurch gekennzeichnet, dass**
die Leiterschleifen beider Transformatoren, die aus dem normalleitenden oder halbleitenden Material bestehen, induktiv voneinander entkoppelt sind.

3. Gyrator nach einem der Ansprüche 1 oder 2,
**dadurch gekennzeichnet, dass**
das Hall-Effekt-Material ein Halbmetall, insbesondere ein Halbmetall aus der Gruppe Arsen, α-Zinn (graues Zinn), Antimon, Wismut oder Graphit, und/oder einen dotierten Halbleiter umfasst.

4. Gyrator nach einem der Ansprüche 1 bis 3,
**dadurch gekennzeichnet, dass**
das Hall-Effekt-Material ein Quanten-Hall-Effekt-Material ist.

5. Gyrator nach Anspruch 4,
**dadurch gekennzeichnet, dass**
das Quanten-Hall-Effekt-Material Graphen und/oder eine Halbleiterheterostruktur, die ein zweidimensionales Elektronengas bildet, umfasst.

6. Gyrator nach einem der Ansprüche 1 bis 5,
**dadurch gekennzeichnet, dass** die genannten mindestens zwei Leiterschleifen (1; 2) aus dem Hall-Effekt-Material an einem Punkt elektrisch miteinander verbunden sind und sich an mindestens einem anderen Punkt ohne elektrische Verbindung kreuzen.

7. Gyrator nach Anspruch 6,
**dadurch gekennzeichnet, dass**
die eine Leiterschleife (1; 2) aus dem Hall-Effekt-Material die Sekundärwicklung des ersten Transformators für die Einkopplung des Eingangsstroms (I₁; I₄) ist und dass die zweite Leiterschleife (2; 1) aus dem Hall-Effekt-Material die Primärwicklung des zweiten Transformators für die Umwandlung des Stroms (I₃; I₂) im Hall-Effekt-Material in die Ausgangsspannung (U₄; U₁) ist.

8. Gyrator nach einem der Ansprüche 1 bis 7,
**dadurch gekennzeichnet, dass**
das Hall-Effekt-Material eine dreidimensionale Fläche belegt, die durch Bewegung einer zweidimensionalen Fläche auf einem geschlossenen Weg im Raum darstellbar ist.

9. Gyrator nach Anspruch 8,
**dadurch gekennzeichnet, dass**
das Hall-Effekt-Material als Schicht auf einem isolierenden Substrat angeordnet ist und/oder die dreidimensionale Fläche einen Hohlkörper aus dem Hall-Effekt-Material bildet.

10. Gyrator nach einem der Ansprüche 8 bis 9,
**dadurch gekennzeichnet, dass**
ein Pfad im Hall-Effekt-Material entlang des geschlossenen Weges oder parallel zu diesem Weg die Sekundärwicklung des ersten Transformators für die Einkopplung des Eingangsstroms (I₁; I₄) oder die Primärwicklung des zweiten Transformators für die Umwandlung des Stroms (I₃; I₂) im Hall-Effekt-Material in die Ausgangsspannung (U₄; U₁) ist.

11. Gyrator nach einem der Ansprüche 8 bis 10,
**dadurch gekennzeichnet, dass**
ein Pfad im Hall-Effekt-Material entlang des Umfangs der zweidimensionalen Fläche an
einem Punkt des geschlossenen Weges die Sekundärwicklung des ersten Transformators für die Einkopplung des Eingangsstroms (I₁; I₄) oder die Primärwicklung des zweiten Transformators für die Umwandlung des Stroms (I₃; I₂) im Hall-Effekt-Material in die Ausgangsspannung (U₄; U₁) ist.

12. Gyrator nach einem der Ansprüche 8 bis 11,
**dadurch gekennzeichnet, dass**
die dreidimensionale Fläche ein Torus ist.

13. Gyrator nach einem der Ansprüche 8 bis 12,
**dadurch gekennzeichnet, dass**
das Hall-Effekt-Material mindestens eine Öffnung zur Durchführung magnetischer Feldlinien durch die dreidimensionale Fläche aufweist.

14. Gyrator nach einem der Ansprüche 8 bis 13,
**gekennzeichnet durch** eine magnetische Multipolanordnung zur Durchsetzung des Hall-Effekt-Materials mit dem Magnetfeld.

15. Gyrator nach einem der Ansprüche 8 bis 14,
**gekennzeichnet durch** Mittel zur Erzeugung eines lokalen elektrischen Hilfsfelds an mindestens einem Ort auf der dreidimensionalen Fläche.

## Claims

1. A gyrator for alternating current signals, comprising a Hall effect material, means for coupling a first alternating current (I₁; I₄) into the Hall effect material, means for enforcing the Hall effect material with a magnetic field being perpendicular to its plane or surface area as well as means for the conversion of a second current (I₃; I₂), which was generated by the first current I₁ being perpendicular to the electrical field in the Hall effect material generated by I₁, into a output voltage (U₄; U₁), wherein the Hall effect material is a material, which has a Hall angle θ_{H} of at least 80 degrees at a magnetic field strength of 1 T, wherein the gyrator comprises a first transformer for the coupling of the first current (I₁; I₄) into the Hall effect material and a second transformer for the conversion of the second current (I₃; I₂) in the Hall effect material into the output voltage (U₄; U₁), wherein the first transformer and the second transformer each comprise at least one conductor loop (1a; 2a) made of a normally conductive or semi-conductive material and at least one conductor loop (1; 2) made of the Hall effect material, wherein the Hall effect material is arranged in the said at least two conductor loops (1; 2) made of the Hall effect material in such a way, that when a magnetic field is applied, an electromotive force in one of the conductor loops made of the Hall effect material of the first transformer causes a current flow mainly in one of the conductor loops made of the Hall effect material of the second transformer.

2. The gyrator according to claim 1, **characterized in that** the conductor loops of both transformers, which consist of the normally conductive or semi-conductive material, are inductively decoupled from one another.

3. The gyrator according to any one of claims 1 or 2, **characterized in that** the Hall effect material comprises a semi-metal, in particular a semi-metal from the group arsenic, α-tin (gray tin), antimony, bismuth or graphite, and/or a doped semiconductor.

4. The gyrator according to any of claims 1 to 3, **characterized in that** the Hall effect material is a quantum Hall effect material.

5. The gyrator according to claim 4, **characterized in that** the quantum Hall effect material comprises graphene and/or a semiconductor heterostructure forming a two-dimensional electron gas.

6. The gyrator according to any one of claims 1 to 5, **characterized in that** the said at least two conductor loops (1; 2) made of the Hall effect material are electrically connected to each other at one point and intersect at least at one other point without an electrical connection.

7. The gyrator according to claim 6, **characterized in that** the one conductor loop (1; 2) made of the Hall effect material is the secondary winding of the first transformer for the coupling of the input current (I₁; I₄) and that the second conductor loop (2; 1) made of the Hall effect material is the primary winding of the second transformer for the conversion of the current (I₃; I₂) in the Hall effect material into the output voltage (U₄; U₁).

8. The gyrator according to any one of claims 1 to 7, **characterized in that** the Hall effect material occupies a three-dimensional surface, which can be represented by movement of a two-dimensional surface on a closed path in space.

9. The gyrator according to claim 8, **characterized in that** the Hall effect material is arranged as a layer on an insulating substrate and/or the three-dimensional surface forms a hollow body made of the Hall effect material.

10. The gyrator according to any one of claims 8 to 9, **characterized in that** a path in the Hall effect material along the closed path or parallel to this path is the secondary winding of the first transformer for the coupling of the input current (I₁; I₄) or the primary winding of the second transformer for the conversion of the current (I₃; I₂) in the Hall effect material into the output voltage (U₄; U₁).

11. The gyrator according to any one of claims 8 to 10 **characterized in that** a path in the Hall effect material along the circumference of the two-dimensional surface at one point of the closed path is the secondary winding of the first transformer for the coupling of the input current (I₁; I₄) or the primary winding of the second transformer for the conversion of the current (I₃; I₂) in the Hall effect material into the output voltage (U₄; U₁).

12. The gyrator according to any one of claims 8 to 11, **characterized in that** the three-dimensional surface is a torus.

13. The gyrator according to any one of claims 8 to 12, **characterized in that** the Hall effect material has at least one opening for the passage of magnetic field lines through the three-dimensional surface.

14. The gyrator according to any one of claims 8 to 13, **characterized by** a magnetic multipole arrangement for enforcing the Hall effect material with the magnetic field.

15. The gyrator according to any one of claims 8 to 14, **characterized by** means for generating a local electrical auxiliary field at least at one location on the three-dimensional surface.

## Revendications

1. Gyrateur pour des signaux en courant alternatif, comprenant un matériau à effet Hall, des moyens d'injection d'un premier courant (I₁ ; I₄) alternatif dans le matériau à effet Hall, des moyens pour faire passer dans le matériau à effet Hall un champ magnétique perpendiculaire à son plan ou sa surface, ainsi que des moyens de transformation d'un deuxième courant (l₃ ; I₂), qui a été produit dans le matériau à effet Hall par le premier courant l₁ perpendiculairement au champ électrique produit par l₁, en une tension (U₄ ; U₁) de sortie, le matériau à effet Hall étant un matériau, qui, pour une intensité du champ magnétique de 1 T, a un angle θ_{H} de Hall d'au moins 80°, le gyrateur comprenant un premier transformateur pour l'injection du premier courant (l₁ ; l₄) dans le matériau à effet Hall et un deuxième transformateur pour la transformation du deuxième courant (l₃ ; l₂) dans le matériau à effet Hall en la tension (U₄ ; U₁) de sortie, le premier transformateur et le deuxième transformateur comprenant chacun au moins une boucle (la ; 2a) conductrice en un matériau normalement conducteur ou semi-conducteur et au moins une boucle (1 ; 2) en le matériau à effet Hall, le matériau à effet Hall étant disposé dans lesdites au moins deux boucles (1 ; 2) conductrices en le matériau à effet Hall, de manière à ce que, lorsque le champ magnétique est appliqué, une force électromotrice dans l'une des boucles conductrices en le matériau à effet Hall du premier transformateur provoque un flux de courant principalement dans l'une des boucles conductrices en le matériau à effet Hall du deuxième transformateur.

2. Gyrateur suivant la revendication 1,
**caractérisé en ce que**
les boucles conductrices des deux transformateurs, qui sont en le matériau normalement conducteur ou semi-conducteur, sont découplées inductivement l'une de l'autre.

3. Gyrateur suivant la revendication 1 ou 2,
**caractérisé en ce que**
le matériau à effet Hall comprend un semi-métal, notamment un semi-métal du groupe de l'arsenic, de l'étain a (étain gris), de l'antimoine, du bismuth ou du graphite et/ou un semi-conducteur dopé.

4. Gyrateur suivant l'une des revendications 1 à 3,
**caractérisé en ce que**
le matériau à effet Hall est un matériau à effet Hall quantique.

5. Gyrateur suivant la revendication 4,
**caractérisé en ce que**
le matériau à effet Hall quantique comprend du graphe et/ou une hétérostructure semi-conductrice, qui forme du gaz d'électrons à deux dimensions.

6. Gyrateur suivant l'une des revendications 1 à 5,
**caractérisé en ce que**
lesdites au moins deux boucles (1 ; 2) conductrices en le matériau à effet Hall sont connectées électriquement l'une à l'autre en un point et se croisent en au moins un autre point, sans connexion électrique.

7. Gyrateur suivant la revendication 6
**caractérisé en ce que**
la une boucle (1 ; 2) conductrice en le matériau à effet Hall est l'enroulement secondaire du premier transformateur pour l'injection du courant (l₁ ; l₄) d'entrée et **en ce que** la deuxième boucle (2 ; 1) conductrice en le matériau à effet Hall est l'enroulement primaire du deuxième transformateur pour la transformation du courant (l₃ ; l₂) dans le matériau à effet Hall en la tension (U₄ ; U₁) de sortie.

8. Gyrateur suivant l'une des revendications 1 à 7,
**caractérisé en ce que**
le matériau à effet Hall occupe une surface en trois dimensions, qui peut être représentée dans l'espace par le déplacement d'une surface à deux dimensions sur un chemin fermé.

9. Gyrateur suivant la revendication 8,
**caractérisé en ce que**
le matériau à effet Hall est disposé sous la forme d'une couche sur un substrat isolant et/ou la surface en trois dimensions forme un corps creux en le matériau à effet Hall.

10. Gyrateur suivant l'une des revendications 8 à 9,
**caractérisé en ce qu'**
un trajet dans le matériau à effet Hall, suivant le chemin fermé ou parallèlement à ce chemin, est l'enroulement secondaire du premier transformateur pour l'injection du courant (l₁ ; l₄) d'entrée ou l'enroulement primaire du deuxième transformateur pour la transformation du courant (l₃ ; l₂) dans le matériau à effet Hall en la tension (U₄ ; U₁) de sortie.

11. Gyrateur suivant l'une des revendications 8 à 10,
caractérisé en qu'
un trajet dans le matériau à effet Hall suivant le pourtour de la surface à deux dimensions sur un point du chemin fermé, est l'enroulement secondaire du premier transformateur pour l'injection du courant (l₁ ; l₄) d'entrée ou l'enroulement primaire du deuxième transformateur pour la transformation du courant (l₃ ; l₂) dans le matériau à effet Hall en la tension (U₄ ; U₁) de sortie.

12. Gyrateur suivant l'une des revendications 8 à 11,
**caractérisé en ce que**
la surface en trois dimensions est un tore.

13. Gyrateur suivant l'une des revendications 8 à 12,
**caractérisé en ce que**
le matériau à effet Hall a au moins une ouverture pour le passage des lignes de champ magnétique à travers la surface en trois dimensions.

14. Gyrateur suivant l'une des revendications 8 à 13,
**caractérisé par** un agencement magnétique multipolaire pour le passage du champ magnétique dans le matériau à effet Hall.

15. Gyrateur suivant l'une des revendications 8 à 14,
**caractérisé par** des moyens de production d'un champ électrique local auxiliaire en au moins un emplacement de la surface à trois dimensions.
